Europäisches Patentamt

European Patent Office

Office européen des brevets

(19)

(11) Veröffentlichungsnummer: **0 118 067**

**A2**

(12) **EUROPÄISCHE PATENTANMELDUNG**

(21) Anmeldenummer: **84101671.0**

(22) Anmeldetag: **17.02.84**

(51) Int. Cl.³: **H 01 L 31/16**

(30) Priorität: **02.03.83 DE 3307263**

(43) Veröffentlichungstag der Anmeldung:
**12.09.84 Patentblatt 84/37**

(84) Benannte Vertragsstaaten:
**FR GB NL**

(71) Anmelder: **TELEFUNKEN electronic GmbH**
**Theresienstrasse 2**
**D-7100 Heilbronn(DE)**

(72) Erfinder: **Angerstein, Jörg, Dr. Dipl.-Phys.**
**Talheimerstrasse 20/1**
**D-7101 Flein(DE)**

(72) Erfinder: **Wagner, Elmar-Ernst, Dr. Dipl.-Phys.**
**Goerdelerstrasse 12**
**D-7100 Heilbronn(DE)**

(72) Erfinder: **Mischel, Peter, Dr. Dipl.-Ing.**
**Friedrich-Dürr-Strasse 103**
**D-7100 Heilbronn(DE)**

(72) Erfinder: **Gillessen, Klaus, Dr. Dipl.-Phys.**
**Im Fuchsloch 13**
**D-7101 Untergruppenbach(DE)**

(72) Erfinder: **Schairer, Werner, Dr. Dipl.-Phys.**
**Masurenweg 1**
**D-7102 Weinsberg(DE)**

(72) Erfinder: **Dermitzakis, Stefanos, Dipl.-Ing.**
**Ludwigstrasse 40**
**D-7100 Heilbronn-Neckargartach(DE)**

(74) Vertreter: **Maute, Hans-Jürgen, Dipl.-Ing.**
**TELEFUNKEN electronic GmbH Theresienstrasse 2**
**D-7100 Heilbronn(DE)**

(54) **Anordnung zur Übertragung elektrischer Signale.**

(57) Bei einer Anordnung zur Übertragung elektrischer Signale mit optischer Kopplung zwischen Sender und Empfänger, bei der als Senderelement eine Leuchtdiode vorgesehen ist, ist die Leuchtdiode eine Galliumaluminiumarsenid-Diode

FIG. 1

EP 0 118 067 A2

**0118067**

TELEFUNKEN electronic GmbH
Theodor-Stern-Kai 1, 6000 Frankfurt 70

Heilbronn, den 17.02.1983
La/goe - HN 83/5

## Anordnung zur Übertragung elektrischer Signale

Die Erfindung betrifft eine Anordnung zur Übertragung
elektrischer Signale mit optischer Kopplung zwischen
Sender und Empfänger, bei der als Senderelement eine
Leuchtdiode vorgesehen ist.

Optokoppler werden beispielsweise zur Übertragung elektrischer Signale bei galvanischer Trennung von Eingangs-
und Ausgangskreis eingesetzt. Sie bestehen aus einem Senderelement (z.B. Glühlampe, lichtemittierende Diode oder
Infrarotemitter) und einem Empfängerelement (z.B. Photowiderstand, Photodiode, Phototransistor), die in einem
gemeinsamen Gehäuse so untergebracht sind, daß die optische Kopplung möglichst gut ist. Die für die Anwendung
wichtigsten Eigenschaften von Optokopplern sind der Koppelfaktor k, das Verhältnis von Ausgangs- zu Eingangsstrom und die Schaltzeit $\tau$, welche die maximale Arbeitsfrequenz bestimmt. Der Koppelfaktor wird durch den Wirkungsgrad der Senderelemente, die Empfindlichkeit des Empfängerelementes und den optischen Aufbau beeinflußt,
während die Schaltzeit insbesondere durch das Element mit
der größeren Schaltzeit gegeben ist. Als Senderelemente
finden heute im wesentlichen die folgenden Halbleiterbauelemente Anwendung:

**0118067**

| Typ | Material | Wellen-länge | Wirkungs-grad | Schalt-zeit |
|-----|----------|--------------|---------------|-------------|
| 1. Infrarotemitter | GaAs:Si | 950 nm | 10 % | 500 ns |
| 2. Infrarotemitter | GaAs:Zn | 910 " | 1 % | 500 " |
| 3. Infrarotemitter | GaAlAs:Si | 870 " | 12 % | 400 " |
| 4. Rotemitter | GaAsP | 660 " | 0,4 % | 80 " |

Als Empfängerelemente werden hauptsächlich Silizium-Phototransistoren und neuerdings auch integrierte Emfpängeranordnungen eingesetzt, die ebenfalls aus Silizium bestehen. Für diese Empfängerelemente und speziell für integrierte Empfänger ist eine kurze Wellenlänge günstig, da die Empfindlichkeit der Siliziumempfänger meist bei 650 - 750 nm maximal ist und bei höheren Wellenlängen stark abfällt. Mit den bekannten Senderelementen können aus den genannten Gründen nicht gleichzeitig hohe Koppelfaktoren und niedrige Schaltzeiten erreicht werden. So erhält man z. B. mit einem Senderelement vom Typ 1 bei einem bestimmten Empfängerelement und einem bestimmten Aufbau einen Koppelfaktor $k = 1$ und eine Schaltzeit $\tau = 500$ ns, während mit einem Senderelement von Typ 2 bei sonst gleichen Bedingungen ein Koppelfaktor $k = 0,2$ und eine Schaltzeit $\tau = 100$ ns erreicht wird.

Der Erfindung liegt die Aufgabe zugrunde, eine Anordnung zur Übertragung elektrischer Signale mit optischer Kopplung zwischen Sender und Empfänger anzugeben, die gleichzeitig einen hohen Koppelfaktor und eine niedrige Schaltzeit aufweist. Diese Aufgabe wird bei einer Anordnung der eingangs erwähnten Art nach der Erfindung dadurch gelöst, daß die Leuchtdiode eine Aluminiumarsenid-Diode ist. Die vorgesehene optische Kopplung kann beispielsweise mittels eines Mediums wie Luft oder mittels eines körperhaften Mediums wie z. B. Kunststoffkörper oder Glasfaser erfolgen.

Die Erfindung wird im folgenden an einem Ausführungsbeispiel näher erläutert.

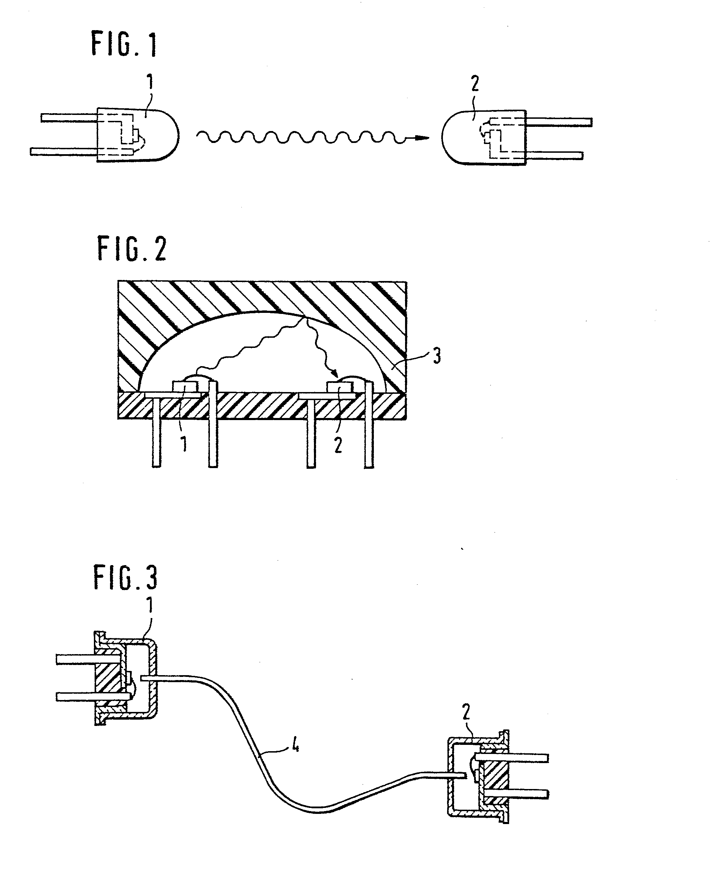

Die Figur 1 zeigt einen Optokoppler, der gemäß der Erfindung als Senderelement eine rot emittierende Leuchtdiode 1 aus GaAlAs aufweist. Als Empfängerelement 2 ist eine integrierte Schaltungsanordnung vorgesehen, die eine Photodiode und einen Schmitt-Trigger aufweist. Die optische Kopplung erfolgt im Ausführungsbeispiel der Figur 1 durch das Medium Luft. Sowohl das Senderelement als auch das Empfängerelement befinden sich in einem Gehäuse.

Die Figur 2 zeigt ein Ausführungsbeispiel der Erfindung, bei dem das Senderelement 1 und das Empfängerelement 2 in einem gemeinsamen Gehäuse 3 untergebracht sind.

Ein Optokoppler nach der Erfindung kann beispielsweise mit einem Eingangsstrom von 5 mA und einer Betriebsfrequenz von 1,2 MHz betrieben werden. Die Betriebsfequenz ist durch die Schaltzeit des Schmitt-Triggers bestimmt. Im Gegensatz dazu beträgt die Betriebsfrequenz bei einem bekannten Senderelement aus GaAs:Si nur 0,4 MHz bei einem Eingangsstrom von 2 mA, während die entsprechenden Daten bei einem bekannten Senderelement aus GaAs:Zn 1 MHz und 15 mA sind.

Die Figur 3 zeigt ein weiteres Ausführungsbeispiel der Erfindung, bei dem die Kopplung zwischen Senderelement und Empängerelement 2 durch eine Glasfaser 4 hergestellt wird.

TELEFUNKEN electronic GmbH
Theodor-Stern-Kai 1, 6000 Frankfurt 70

**0118067**

Heilbronn, den 17.02.1983
La/goe -  HN 83/5

Patentansprüche

1) Anordnung zur Übertragung elektrischer Signale mit optischer Kopplung zwischen Sender und Empfänger, bei der als Senderelement eine Leuchtdiode vorgesehen ist, dadurch gekennzeichnet, daß die Leuchtdiode eine Galliumaluminiumarsenid-Diode ist.

2) Anordnung nach Anspruch 1, dadurch gekennzeichnet, daß die Wellenlänge der vom Senderelement emittierten Strahlung im Bereich 600 bis 750 nm liegt.

3) Anordnung nach Anspruch 1 oder 2, dadurch gekennzeichnet, daß die als Senderelement vorgesehene Leuchtdiode  zwei Epitaxieschichten unterschiedlichen Leitungstyps und mit unterschiedlichem Aluminiumgehalt aufweist.

FIG.1

FIG.2

FIG.3